# EUROPEAN PATENT APPLICATION

(11) **EP 4 633 341 A1**
(43) Date of publication of application: **15.10.2025**
(21) Application number: 23955718.4
(22) Date of filing: 18.10.2023
(51) Int. Cl.: H10K 59/122

(54) **DISPLAY SUBSTRATE AND MANUFACTURING METHOD THEREFOR, AND DISPLAY DEVICE**

(71) Applicant: Boe Technology Group Co., Ltd., Beijing 100015 (CN); Yunnan Invensight Optoelectronics Technology Co., Ltd., Kunming, Yunnan 650211 (CN)
(72) Inventor: YANG, Yifan, Beijing 100176 (CN); ZHANG, Fugang, Beijing 100176 (CN); KONG, Lingchen, Beijing 100176 (CN); HOU, Xiaoyan, Beijing 100176 (CN); TAN, Bin, Beijing 100176 (CN); ZHANG, Dacheng, Beijing 100176 (CN)
(74) Representative: CMS Cameron McKenna Nabarro Olswang LLP
(86) International application number: PCT/CN2023/125283
(87) International publication number: WO 2025/081391

(57) **Abstract**

A display substrate and a manufacturing method therefor, and a display device. The display substrate comprises a plurality of first electrodes (31) and a plurality of pixel definition structures (32) which are arranged on a base substrate (10), wherein each pixel definition structure (32) is arranged between adjacent first electrodes (31), and forms a pixel opening (35) exposing the first electrodes (31); and each pixel definition structure (32) comprises at least a first insulating layer (101), a second insulating layer (102), a third insulating layer (103) and a fourth insulating layer (104). The orthographic projection of the second insulating layer (102) on the base substrate (10) at least partially overlaps the orthographic projection of the first electrode (31) on the base substrate (10); second recesses (106) are provided in the surface of the second insulating layer (102); and an inner wall on the side of each second recess (106) close to the base substrate (10) is located between the surface on the side of the first electrode (31) away from the base substrate (10) and the surface on the side of the first electrode (31) close to the base substrate (10).

## Description

### Technical Field

Embodiments of the present invention relate to, but are not limited to, the field of display technology, and in particular to a display substrate and a manufacturing method therefor, and a display apparatus.

### Background

Micro organic light emitting diode (Micro-OLED) is a micro display developed in recent years, and silicon-based OLED is one of them. The silicon-based OLED can not only realize active addressing of pixels, but also can realize manufacturing of structures such as pixel drive circuits on a silicon-based substrate, which is conducive to reduce system volume and realize lightweight. A silicon-based OLED is prepared by mature Complementary Metal Oxide Semiconductor (CMOS) integrated circuit process, which has the advantages of small size, high resolution (Pixels Per Inch, PPI), high refresh rate or the like and is widely used in the near-eye display field of Virtual Reality (VR) or Augmented Reality (AR).

### Summary

The following is a summary of subject matters described herein in detail. This summary is not intended to limit the protection scope of claims.

In a first aspect of an embodiment of the present disclosure, an embodiment of the present disclosure provides a display substrate including a base substrate, and a plurality of first electrodes and a plurality of pixel definition structures disposed on the base substrate. The pixel definition structures are disposed between adjacent first electrodes and form pixel openings exposing the first electrodes. In a direction perpendicular to the base substrate, a pixel definition structure at least includes a first insulating layer disposed on the base substrate, a second insulating layer disposed on a side of the first insulating layer away from the base substrate, a third insulating layer disposed on a side of the second insulating layer away from the base substrate, and a fourth insulating layer disposed on a side of the third insulating layer away from the base substrate. Orthographic projections of the first insulating layer, the third insulating layer and the fourth insulating layer on the base substrate do not overlap an orthographic projection of a first electrode on the base substrate, and an orthographic projection of the second insulating layer on the base substrate at least partially overlaps the orthographic projection of the first electrode on the base substrate. A surface of the second insulating layer away from the base substrate is provided with a second recess recessed in a direction toward the base substrate, and an inner wall of the second recess on a side close to the base substrate is located between a surface of the first electrode on a side away from the base substrate and a surface of the first electrode on a side close to the base substrate.

In an exemplary implementation, a second depth of the second recess is 0.01µm to 0.06µm, and the second depth is a maximum distance between an inner wall of the second recess on a side close to the base substrate and a surface of the second insulating layer on a side away from the base substrate.

In an exemplary implementation, a surface of the first insulating layer on a side away from the base substrate is flush with a surface of the first electrode on a side away from the base substrate, or a surface of the first insulating layer on a side away from the base substrate is lower than a surface of the first electrode on a side away from the base substrate.

In an exemplary implementation, the first insulating layer has a first width, the second insulating layer has a second width, the second width is greater than the first width, and the first width and the second width are dimensions in a direction parallel to the base substrate.

In an exemplary implementation, a difference between the second width and the first width is greater than or equal to 0.1µm.

In an exemplary implementation, a material of the third insulating layer is different from a material of the fourth insulating layer, and a material of the second insulating layer is the same as a material of the fourth insulating layer.

In an exemplary implementation, the third insulating layer has a third width, the fourth insulating layer has a fourth width, the fourth width is less than the second width, the fourth width is less than the first width, the third width is less than the fourth width, and the third width and the fourth width are dimensions in a direction parallel to the base substrate.

In an exemplary implementation, a difference between the fourth width and the second width is greater than or equal to 0.3µm, and a difference between the fourth width and the third width is 0.1µm to 0.4µm.

In an exemplary implementation, the fourth insulating layer has a protrusion relative to a side wall of the third insulating layer, and the protrusion and the side wall of the third insulating layer form a first recess recessed in a direction away from a pixel opening. A first depth of the first recess is greater than the second depth of the second recess. The first depth is a maximum distance between a side wall of the fourth insulating layer on a side close to the pixel opening and a side wall of the third insulating layer on a side close to the pixel opening.

In an exemplary implementation, the first depth of the first recess is 0.05µm to 0.2µm.

In an exemplary implementation, a first height of the first recess is greater than the second depth of the second recess, and the first height of the first recess is a maximum distance between a surface of the first recess on a side close to the base substrate and a surface of the first recess on a side away from the base substrate.

In an exemplary implementation, a surface of the fourth insulating layer on a side away from the base substrate is provided with a third recess that is smoothly recessed in a direction toward the base substrate.

In an exemplary implementation, a curvature of the third recess is less than a curvature of the first recess or a curvature of the second recess.

In an exemplary implementation, the display substrate further includes an organic light emitting layer disposed on a side of the first electrodes and the pixel definition structures away from the base substrate. The organic light emitting layer includes a plurality of film layers, at least one film layer is broken at an edge of the fourth insulating layer, and a film layer of the organic light emitting layer is provided with a distortion region at a broken position.

In an exemplary implementation, the distortion region may include at least one crack, and an orthographic projection of the distortion region on the base substrate does not overlap an orthographic projection of the pixel openings on the base substrate.

In an exemplary implementation, the display substrate further includes a second electrode disposed on a side of the organic light emitting layer away from the base substrate. The second electrode is provided with a puncture tip disposed in the crack in the distortion region. An orthographic projection of the puncture tip on the base substrate does not overlap an orthographic projection of the first electrode on the base substrate.

An orthographic projection of an end point of the puncture tip on the base substrate is located within a range of an orthographic projection of the first insulating layer on the base substrate, and the end point of the puncture tip is a boundary point closest to the base substrate on the puncture tip.

In an exemplary implementation, the organic light emitting layer includes a first device, a charge generation layer and a second device which are stacked. The first device and the charge generation layer have a first device thickness, and the second device has a second device thickness. The first device thickness is smaller than the second device thickness, and the first device thickness and the second device thickness is dimensions in a direction perpendicular to the base substrate.

In an exemplary implementation, the first device thickness is less than 1/2 * the second device thickness.

In an exemplary implementation, the third insulating layer has a third thickness D3, and the third thickness D3 is a dimension in a direction perpendicular to the base substrate. The third thickness is less than the first device thickness, and the third thickness is greater than 1/2 * the first device thickness.

In a second aspect of an embodiment of the present disclosure, an embodiment of the present disclosure provides a display apparatus including the aforementioned display substrate.

In a third aspect of an embodiment of the present disclosure, an embodiment of the present disclosure provides a manufacturing method for a display substrate. The manufacturing method includes: forming a plurality of first electrodes and a plurality of pixel definition structures on a base substrate. The pixel definition structures are disposed between adjacent first electrodes and form pixel openings exposing the first electrodes. In a direction perpendicular to the base substrate, a pixel definition structure at least includes a first insulating layer disposed on the base substrate, a second insulating layer disposed on a side of the first insulating layer away from the base substrate, a third insulating layer disposed on a side of the second insulating layer away from the base substrate, and a fourth insulating layer disposed on a side of the third insulating layer away from the base substrate. Orthographic projections of the first insulating layer, the third insulating layer and the fourth insulating layer on the base substrate do not overlap an orthographic projection of a first electrode on the base substrate, and an orthographic projection of the second insulating layer on the base substrate at least partially overlaps the orthographic projection of the first electrode on the base substrate. A surface of the second insulating layer away from the base substrate is provided with a second recess recessed in a direction toward the base substrate, and an inner wall of the second recess on a side close to the base substrate is located between a surface of the first electrode on a side away from the base substrate and a surface of the first electrode on a side close to the base substrate.

Other aspects of the present disclosure may be comprehended after the drawings and the detailed description are read and understood.

### Brief Description of Drawings

Accompanying drawings are used for providing an understanding of technical solutions of the present application and form a part of the specification, are used for explaining the technical solutions of the present application together with embodiments of the present application, and do not constitute a limitation on the technical solutions of the present application. Shapes and sizes of various components in the drawings do not reflect actual scales, but are only intended to schematically illustrate contents of the present disclosure.
FIG. 1 is a schematic diagram of a structure of a display apparatus.
FIG. 2 is a schematic diagram of a planar structure of a display substrate.
FIG. 3 is a schematic diagram of a cross-sectional structure of a display substrate.
FIG. 4 is a schematic diagram of a structure of a display substrate according to an exemplary embodiment of the present disclosure.
FIG. 5 is an enlarged view of a pixel definition structure of a display substrate in an exemplary embodiment of the present disclosure.
FIG. 6 is a schematic diagram after a pattern of a first conductive layer is formed according to an exemplary embodiment of the present disclosure.
FIG. 7A is a first schematic diagram after a pattern of a pixel definition structure is formed according to an exemplary embodiment of the present disclosure.
FIG. 7B is a second schematic diagram after a pattern of a pixel definition structure is formed according to an exemplary embodiment of the present disclosure.
FIG. 7C is a third schematic diagram after a pattern of a pixel definition structure is formed according to an exemplary embodiment of the present disclosure.
FIG. 7D is a fourth schematic diagram after a pattern of a pixel definition structure is formed according to an exemplary embodiment of the present disclosure.
FIG. 7E is a fifth schematic diagram after a pattern of a pixel definition structure is formed according to an exemplary embodiment of the present disclosure.
FIG. 7F is a sixth schematic diagram after a pattern of a pixel definition structure is formed according to an exemplary embodiment of the present disclosure.
FIG. 7G is a seventh schematic diagram after a pattern of a pixel definition structure is formed according to an exemplary embodiment of the present disclosure.
FIG. 7H is an eighth schematic diagram after a pattern of a pixel definition structure is formed according to an exemplary embodiment of the present disclosure.
FIG. 8 is a schematic diagram after a pattern of an organic light emitting layer is formed according to an exemplary embodiment of the present disclosure.
FIG. 9 is a schematic diagram after a pattern of a second conductive layer is formed according to an exemplary embodiment of the present disclosure.
FIG. 10 is a schematic diagram of a structure of an organic light emitting layer in an exemplary embodiment of the present disclosure.
FIG. 11 is a schematic diagram of a structure of another organic light emitting layer in an exemplary an exemplary embodiment of the present disclosure.

**Description of reference signs in the drawing:**

| | | | | | |
|---|---|---|---|---|---|
| 10- | Base substrate; | 20- | Drive circuit layer; | 30- | Light emitting structure layer; |
| 31- | First electrode; | 32- | Pixel definition structure; | 33- | layer; Organic light emitting |
| 34- | Second electrode; | 35- | Pixel opening. | 40- | First encapsulation layer; |
| 50- | Color film structure layer; | 60- | Second encapsulation layer; | 70- | Cover plate layer; |
| 101 | First insulating layer; | 102- | Second insulating layer; | 103- | Third insulating layer; |
| 104 - | Fourth insulating layer; | 105- | First recess; | 106- | Second recess; |
| 107 - | Distortion region; | 108- | Puncture tip; | 109- | Third recess; |
| 111 - | First photoresist pattern; | 112- | Second photoresist pattern; | 33-1- | First device; |
| 33-2- | charge generation layer; | 33-3- | Second device. | | |

### Detailed Description

Implementations herein may be implemented in multiple different forms. Those of ordinary skills in the art can readily appreciate such a fact that the implementations and contents may be varied into various forms without departing from the spirit and scope of the present disclosure. Therefore, the present disclosure should not be explained as being limited to the contents recorded in the following implementations only. The embodiments and features in the embodiments of the present disclosure may be randomly combined with each other if there is no conflict.

Scales of the drawings in the present disclosure may be used as a reference in actual processes, but are not limited thereto. For example, a width-length ratio of a channel, a thickness and spacing of each film layer, and a width and spacing of each signal line may be adjusted according to actual needs. A quantity of pixels in a display substrate and a quantity of sub-pixels in each pixel are not limited to numbers shown in the drawings. The drawings described in the present disclosure are schematic structural diagrams only, and one mode of the present disclosure is not limited to shapes, numerical values, or the like shown in the drawings.

Ordinal numerals such as "first", "second", and "third" herein are set to avoid confusion between constituent elements, but are not intended to limit in terms of quantity.

Herein, for convenience, wordings indicating orientations or positional relationships, such as "center", "upper", "lower", "front", "back", "vertical", "horizontal", "top", "bottom", "inside", "outside", are used to describe the positional relationships between the constituent elements with reference to the accompanying drawings, and are merely for facilitating describing the implementations and simplifying the specification, rather than indicating or implying that the referred apparatuses or elements must have particular orientations, or are constructed and operated in particular orientations. Thus, they cannot be construed as a limitation on the present disclosure. The positional relationships between the constituent elements can be appropriately changed according to directions in which the constituent elements are described. Therefore, appropriate replacements can be made according to situations without being limited to the wordings described in the specification.

Herein, unless otherwise specified and defined explicitly, terms "mount", "couple", "connect" should be understood in a broad sense. For example, a connection may be a fixed connection, or a detachable connection, or an integral connection; it may be a mechanical connection or an electrical connection; it may be a direct connection, or an indirect connection through middleware, or internal communication between two elements. Those of ordinary skills in the art may understand meanings of the aforementioned terms in the present disclosure according to situations.

Herein, a transistor refers to an element at least including three terminals, i.e., a gate electrode, a drain electrode, and a source electrode. A transistor has a channel region between a drain electrode (or referred to as a drain electrode terminal, a drain region, or a drain electrode) and a source electrode (or referred to as a source electrode terminal, a source region, or a source electrode), and a current can flow through the drain electrode, the channel region, and the source electrode. Herein, the channel region refers to a region through which the current mainly flows.

Herein, a first pole may be the drain electrode and a second pole may be the source electrode; or, the first pole may be the source electrode and the second pole may be the drain electrode. Functions of the "source electrode" and the "drain electrode" are sometimes interchangeable in a situation in which transistors with opposite polarities are used or a current direction changes during working of a circuit. Therefore, the "source electrode" and the "drain electrode" are interchangeable herein.

Herein, an "electrical connection" includes a case that constituent elements are connected together through an element with certain electrical action. An "element with a certain electrical action" is not particularly limited as long as electrical signals may be sent and received between the connected constituent elements. For example, the "element with a certain electrical action" may be an electrode or wiring, or a switch element (such as a transistor), or other functional elements, such as a resistor, an inductor, a capacitor, or the like.

Herein, "parallel" refers to a state in which an angle formed by two straight lines is -10° or more and 10° or less, and thus also includes a state in which the angle is -5° or more and 5° or less. In addition, "perpendicular" refers to a state in which an angle formed by two straight lines is 80° or more and 100° or less, and thus also includes a state in which the angle is 85° or more and 95° or less.

Herein, a "film" and a "layer" are interchangeable. For example, a "conductive layer" may be replaced with a "conductive film" sometimes. Similarly, an "insulating film" may be replaced with an "insulating layer" sometimes.

"About" herein refers to that a boundary is defined not so strictly and numerical values within process and measurement error ranges are allowed.

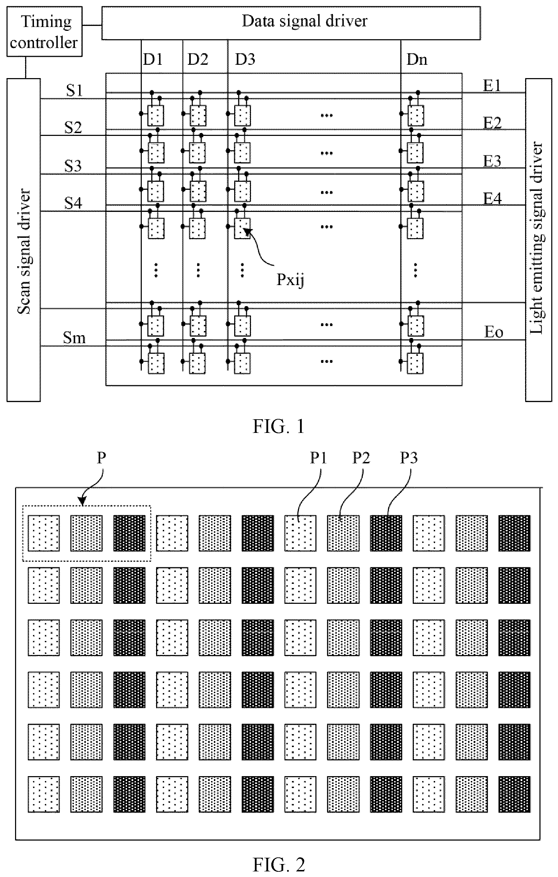

FIG. 1 is a schematic diagram of a structure of a display apparatus. As shown in FIG. 1, an OLED display apparatus may include a timing controller, a data signal driver, a scan signal driver, a light emitting signal driver, and a pixel array. The pixel array may include multiple scan signal lines (S1 to Sm), multiple data signal lines (D1 to Dn), multiple light emitting signal lines (E1 to Eo), and multiple sub-pixels Pxij. In an exemplary implementation, the timing controller may provide a gray scale value and a control signal suitable for a specification of the data signal driver to the data signal driver, may provide a clock signal, and a scan start signal, etc., suitable for a specification of the scan signal driver to the scan signal driver, and may provide a clock signal, and an emission stop signal, etc., suitable for a specification of the light emitting signal driver to the light emitting signal driver. The data signal driver may generate data voltages to be provided to data signal lines D1, D2, D3, ..., and Dn by using the gray scale value and the control signal received from the timing controller. For example, the data signal driver may sample the gray scale value by using a clock signal and apply a data voltage corresponding to the gray scale value to the data signal lines D1 to Dn by taking a pixel row as a unit, wherein n may be a natural number. The scan signal driver may generate scan signals to be provided to scan signal lines S1, S2, S3, ..., and Sm by receiving a clock signal, a scan start signal, and the like from the timing controller. For example, the scan signal driver may sequentially provide scan signals with turning-on-level pulses to the scan signal lines S1 to Sm. For example, the scan signal driver may be constructed in a form of a shift register, and generate the scan signals in a manner of sequentially transmitting the scan start signal provided in a form of turning-on-level pulses to a next-stage circuit under control of the clock signal, wherein m may be a natural number. The light emitting signal driver may generate emission signals to be provided to the light emitting signal lines E1, E2, E3, ..., and Eo by receiving the clock signal, the transmission stop signal, and the like from the timing controller. For example, the light emitting signal driver may sequentially provide an emission signal with an off-level pulse to the light emitting signal lines E1 to Eo. For example, the light emitting signal driver may be constructed in a form of a shift register and generate a light emitting signal in a manner of sequentially transmitting a light emitting stop signal provided in a form of an off-level pulse to a next-stage circuit under control of a clock signal, wherein o may be a natural number. The pixel array may include multiple sub-pixels Pxij. Each sub-pixel Pxij may be connected with the corresponding data signal line, the corresponding scan signal line, and the corresponding light emitting signal line. Herein, i and j may be natural numbers. The sub-pixel Pxij may refer to a sub-pixel of which a transistor is connected to an i-th scan signal line and connected to a j-th data signal line. In an exemplary implementation, the pixel array may be disposed on a display substrate.

FIG. 2 is a schematic diagram of a planar structure of a display substrate. As shown in FIG. 2, the display substrate may include multiple pixel units P arranged in a matrix. At least one of the multiple pixel units P includes a first sub-pixel P1 emitting light of a first color, a second sub-pixel P2 emitting light of a second color, and a third sub-pixel P3 emitting light of a third color, and the first sub-pixel P1, the second sub-pixel P2, and the third sub-pixel P3 each includes a pixel drive circuit and a light emitting device. Pixel drive circuits in the first sub-pixel P1, the second sub-pixel P2, and the third sub-pixel P3 are connected with a scan signal line, a data signal line, and a light emitting signal line respectively. A pixel drive circuit is configured to receive a data voltage transmitted by the data signal line under control of the scan signal line and the light emitting signal line, and output a corresponding current to the light emitting device. Light emitting devices in the first sub-pixel P1, the second sub-pixel P2, and the third sub-pixel P3 are respectively connected with a pixel drive circuit of a sub-pixel in which the light emitting device is located, and the light emitting device is configured to emit light with a corresponding brightness in response to a current outputted by the pixel drive circuit of the sub-pixel in which the light emitting device is located.

In an exemplary implementation mode, a pixel unit P may include a Red (R) sub-pixel, a Green (G) sub-pixel, and a Blue (B) sub-pixel, or may include a red sub-pixel, a green sub-pixel, a blue sub-pixel, and a white sub-pixel, which is not limited in the present disclosure. In an exemplary implementation, a shape of a sub-pixel in a pixel unit may be a rectangle, a rhombus, a pentagon, or a hexagon. When the pixel unit includes three sub-pixels, the three sub-pixels may be arranged side by side horizontally, side by side vertically, or in a manner like a Chinese character " 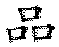 ". When the pixel unit includes four sub-pixels, the four sub-pixels may be arranged side by side horizontally, side by side vertically, or in a manner to form a square, which is not limited in the present disclosure.

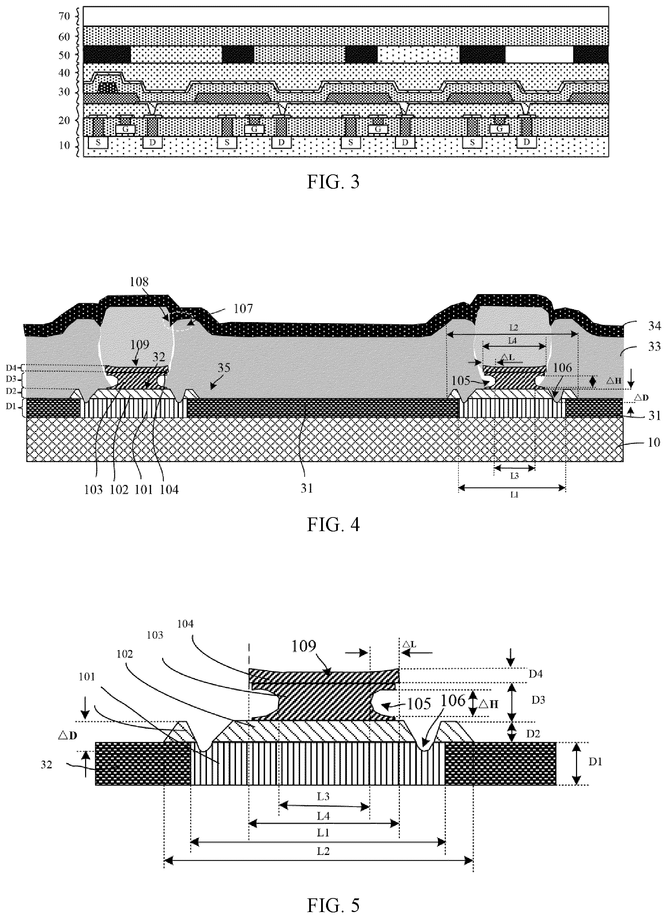

FIG. 3 is a schematic diagram of a cross-sectional structure of a display substrate, illustrating a structure in which full color is realized by using a white light and color film. As shown in FIG. 3, a display substrate of a silicon-based OLED display apparatus may include a base substrate 10, a drive circuit layer 20 disposed on the base substrate 10, a light emitting structure layer 30 disposed on a side of the drive circuit layer 20 away from the base substrate 10, a first encapsulation layer 40 disposed on a side of the light emitting structure layer 30 away from the base substrate 10, a color film structure layer 50 disposed on a side of the first encapsulation layer 40 away from the base substrate 10, a second encapsulation layer 60 disposed on a side of the color film structure layer 50 away from the base substrate 10, and a cover plate layer 70 disposed on a side of the second encapsulation layer 60 away from the base substrate 10. In some possible implementations, the display substrate may include other film layers, and the present disclosure is not limited thereto.

In an exemplary implementation, the base substrate 10 may be a bulk silicon substrate or a silicon-on-insulation (SOI) substrate. The drive circuit layer 20 may be fabricated on the base substrate 10 by a silicon semiconductor process (e.g., a CMOS process). The drive circuit layer 20 may include a plurality of circuit units. At least one circuit unit may include a pixel drive circuit connected to a scan signal line and a data signal line. At least one pixel drive circuit may include a plurality of transistor and a storage capacitor. In FIG. 3, only the pixel drive circuit including one transistor is taken as an example. A transistor may include a control electrode, a first pole, and a second pole. The control electrode, the first pole, and the second pole may be respectively connected with corresponding connection electrodes through vias filled with wolfram metal (i.e., wolfram vias, W-vias), and may be connected with other electrical structures (such as wires) through the connection electrodes.

In an exemplary implementation, the light emitting structure layer 30 may include a plurality of light emitting devices, and the light emitting device of the light emitting structure layer 30 may be an organic light emitting diode (OLED) or a quantum dot light emitting diode (QLED) or the like. An embodiment of the present disclosure does not limit the type of the light emitting device. The light emitting device may at least include a first electrode, an organic light emitting layer, and a second electrode. The first electrode may be connected to a second pole of the transistor by a connection electrode. The organic light emitting layer may be connected to the first electrode. The second electrode may be connected to the organic light emitting layer. The second electrode may be connected to a second power line. The organic light emitting layer emits light under the drive of the first electrode and the second electrode. The first electrode may be provided on the side of the drive circuit layer 20 away from the base substrate 10, and the organic light emitting layer and the second electrode may be stacked sequentially on a side of the first electrode away from the base substrate 10.

In an exemplary implementation, the light emitting structure layer 30 may also include a pixel definition layer. The pixel definition layer of each sub-pixel is provided with a pixel opening. The pixel opening exposes the first electrode such that the organic light emitting layer is connected to the first electrode through the pixel opening.

In an exemplary implementation, since the organic light emitting layer emits light at a pixel opening region provided in the pixel definition layer, the sub-pixels may include a pixel light emitting area and a pixel spacer region. The pixel light emitting area is a light emitting region. An area other than the pixel opening is the pixel spacer region. The pixel spacer region is located on a periphery of the light emitting region.

In an exemplary implementation, the first encapsulation layer 40 and the second encapsulation layer 60 may be encapsulated in a manner of Thin Film Encapsulation (TFE), so as to ensure that external water vapor cannot enter the organic light emitting layer. The cover plate layer 70 may be made of glass, or plastic colorless polyimide having flexible characteristics, etc.

In an exemplary implementation, the color filter structure layer 50 may include a black matrix (BM) and color filters (CF). The color filters are provided in red sub-pixels, green sub-pixels and blue sub-pixels respectively, and filter white light emitted by the light emitting devices into red (R) light, green (G) light and blue (B) light. The black matrix may be located between adjacent color filters.

In an exemplary implementation, the organic light emitting layer is configured to emit white light and may be prepared by means of evaporation deposition or inkjet printing. The organic light emitting layer of all sub-pixels may be a common layer connected together.

The resolution and brightness requirements of silicon-based OLED screens are getting higher. Its brightness has exceeded 5000nits, the resolution requirement has exceeded 3000PPI, and the sub-pixel pitch has entered the level of 1µm, which further exposes issues such as lateral leakage of some film layers in the organic light emitting layer, lateral current crosstalk between adjacent sub-pixels. At present, a variety of solutions have been proposed in the related art for the issue of lateral current crosstalk, such as adjusting the pixel pitch and adjusting the highly conductive organic film layer material. After research, it has been found that these solutions not only have limited effect on cutting off lateral leakage, but also affect the voltage of light emitting devices, reduce the luminous efficiency, and cause a large loss of brightness.

An embodiment of the present disclosure provides a display substrate including a base substrate, and a plurality of first electrodes and a plurality of pixel definition structures disposed on the base substrate. The pixel definition structures are disposed between adjacent first electrodes and form pixel openings exposing the first electrodes. **In** a direction perpendicular to the base substrate, a pixel definition structure at least includes a first insulating layer disposed on the base substrate, a second insulating layer disposed on a side of the first insulating layer away from the base substrate, a third insulating layer disposed on a side of the second insulating layer away from the base substrate, and a fourth insulating layer disposed on a side of the third insulating layer away from the base substrate. Orthographic projections of the first insulating layer, the third insulating layer and the fourth insulating layer on the base substrate do not overlap an orthographic projection of a first electrode on the base substrate. An orthographic projection of the second insulating layer on the base substrate at least partially overlaps the orthographic projection of the first electrode on the base substrate. A surface of the second insulating layer away from the base substrate is provided with a second recess recessed in a direction toward the base substrate, and an inner wall of the second recess on a side close to the base substrate is located between a surface of the first electrode on a side away from the base substrate and a surface of the first electrode on a side close to the base substrate.

The display substrate provided by this embodiment can function as a partition for the organic light emitting layer by the pixel definition structure, so as to cut off the lateral leakage, and at the same time prevent the second electrode from breaking, so as to improve the display effect.

In an exemplary implementation, a second depth of the second recess is 0.01µm to 0.06µm, and the second depth is a maximum distance between an inner wall of the second recess on a side close to the base substrate and a surface of the second insulating layer on a side away from the base substrate.

In an exemplary implementation, a surface of the first insulating layer on a side away from the base substrate is flush with a surface of the first electrode on a side away from the base substrate. A surface of the first insulating layer on a side away from the base substrate is lower than a surface of the first electrode on a side away from the base substrate.

In an exemplary implementation, a material of the third insulating layer is different from a material of the fourth insulating layer, and a material of the second insulating layer is the same as the material of the fourth insulating layer.

In an exemplary implementation, the fourth insulating layer has a protrusion relative to a side wall of the third insulating layer. The protrusion and the side wall of the third insulating layer form a first recess recessed in a direction away from a pixel opening. A first depth of the first recess is greater than a second depth of the second recess. The first depth is a maximum distance between a side wall of the fourth insulating layer on a side close to the pixel opening and a side wall of the third insulating layer on a side close to the pixel opening.

In an exemplary implementation, the display substrate further includes an organic light emitting layer disposed on a side of the first electrode and the pixel definition structure away from the base substrate. The organic light emitting layer includes a plurality of film layers. At least one film layer is broken at an edge of the fourth insulating layer. The film layer of the organic light emitting layer forms a distortion region at a broken position.

FIG. 4 is a schematic diagram of a structure of a display substrate in an exemplary embodiment of the present disclosure, and FIG. 5 is an enlarged view of the pixel definition structure in FIG. 4. As shown in FIGS. 4 and 5, the display substrate of the present exemplary embodiment may include a base substrate 10, a plurality of first electrodes 31 and a plurality of pixel definition structures 32 provided on the base substrate 10, an organic light emitting layer 33 provided on a side of the first electrodes 31 and the pixel definition structures 32 away from the base substrate 10, and a second electrode 34 provided on a side of the organic light emitting layer 33 away from the base substrate 10.

In an exemplary implementation, the pixel definition structures 32 are provided between adjacent first electrodes 31 and forms pixel openings 35 that expose the first electrodes 31, and a pixel definition structure 32 may include a plurality of inorganic layers stacked on the base substrate 10.

In an exemplary implementation, the plurality of inorganic layers of the pixel definition structure 32 may include at least a first insulating layer 101 disposed on the base substrate 10, a second insulating layer 102 disposed on the side of the first insulating layer 101 away from the base substrate 10, a third insulating layer 103 disposed on a side of the second insulating layer 102 away from the base substrate 10, and a fourth insulating layer 104 disposed on a side of the third insulating layer 103 away from the base substrate 10.

In an exemplary implementation, the first insulating layer 101 is disposed between adjacent first electrodes 31, and a side surface of the first insulating layer 101 may be bonded to a side surface of the first electrode 31. An orthographic projection of the first insulating layer 101 on the base substrate 10 does not overlap an orthographic projection of the first electrode 31 on the base substrate 10.

In an exemplary embodiment, a surface of the first insulating layer 101 on a side away from the base substrate 10 is substantially flush with a surface of the first electrode 31 on a side away from the base substrate 10. A surface of the first insulating layer 101 on a side away from the base substrate 10 is lower than a surface of the first electrode 31 on the side away from the base substrate 10.

In an exemplary implementation, the first insulating layer 101 has a first width L1, and the first width L1 is a dimension of the first insulating layer 101 in a direction parallel to the base substrate 10.

In an exemplary implementation, the first width L1 may be about 1.0µm to 1.2µm. For example, the first width L1 may be about 1.1µm.

In an exemplary implementation, an orthographic projection of the second insulating layer 102 on the base substrate 10 at least partially overlaps an orthographic projection of the first electrode 31 on the base substrate 10. The second insulating layer 102 has a second width L2, and the second width L2 is a dimension of the second insulating layer 102 in a direction parallel to the base substrate 10.

In an exemplary implementation, the second width L2 of the second insulating layer 102 is greater than the first width L1 of the first insulating layer 101, i.e., L2 > L1.

In an exemplary implementation, a difference between the second width L2 and the first width L1 is greater than or equal to 0.1µm. The second width L2 may be about 1.2µm to 1.6µm. For example, the second width L2 may be about 1.4µm.

In an exemplary implementation, a width of a region where the second insulating layer 102 overlaps the first electrode 31 is greater than or equal to 0.1µm, so that the second insulating layer 102 can effectively cover the edges of the first electrode 31. That is, the pixel definition structure 32 does not expose an edge of the first electrode 31 and is provided by forming a second insulating layer 102 which is wider than the first insulating layer 101.

In an exemplary implementation, the difference between the second width L2 and the first width L1 may be about 0.3µm, such that the second insulating layer 102 effectively covers one side of the first electrode 31 by about 0.15µm.

In an exemplary embodiment, an orthographic projection of the third insulating layer 103 on the base substrate 10 does not overlap an orthographic projection of the first electrode 31 on the base substrate 10. An orthographic projection of the fourth insulating layer 104 on the base substrate 10 does not overlap an orthographic projection of the first electrode 31 on the base substrate 10.

In an exemplary implementation, a material of the third insulating layer 103 may be different from a material of the fourth insulating layer 104, and a material of the second insulating layer 102 may be the same as the material of the fourth insulating layer 104, so that an recessed structure can be produced due to differences in the etch rates of the two materials. For example, the materials of the second insulating layer 102 and the fourth insulating layer 104 may both be silicon oxide (SiOx). The material of the third insulating layer 103 may be silicon nitride (SiNx).

In an exemplary implementation, the third insulating layer 103 has a third width L3, and the fourth insulating layer 104 has a fourth width L4. The fourth width L4 may be larger than the third width L3, and the third width L3 and the fourth width L4 are dimensions in a direction parallel to the base substrate 10.

In an exemplary implementation, the third width L3 may be a minimum width of the third insulating layer 103, and the fourth width L4 may be a maximum width of the fourth insulating layer 104. Alternatively, the third width L3 may be an average width of the third insulating layer 103, and the fourth width L4 may be an average width of the fourth insulating layer 104.

In an exemplary implementation, the difference between the fourth width L4 and the third width L3 may be about 0.1µm to 0.4µm.

In an exemplary implementation, the third width L3 may be about 0.3µm to 0.5µm. In an exemplary implementation, the third width L3 may be about 0.4µm. The fourth width L4 may be about 0.5µm to 0.7µm. For example, the fourth width L4 may be about 0.6µm.

In an exemplary implementation, the fourth width L4 may be smaller than the first width L1, i.e., L4 < L1.

In an exemplary implementation, the fourth width L4 may be smaller than the second width L2, i.e., L4 < L2. The difference between the fourth width L4 and the second width L2 is greater than or equal to 0.3µm.

In an exemplary embodiment, the fourth insulating layer 104 has a protrusion relative to a side wall of the third insulating layer 103, and the protrusion and the side wall of the third insulating layer 103 form a first recess 105 recessed in a direction away from the pixel opening 35. The first recess 105 may be in the shape of a curved surface with curvature.

In an exemplary implementation, the first recess 105 may have a first depth △L. The first depth △L may be a maximum distance between a side wall of the fourth insulating layer 104 on a side close to the pixel opening 35 and a side wall of the third insulating layer 103 on a side close to the pixel opening 35. The first depth △L may be a dimension in a direction parallel to the base substrate 10.

In an exemplary implementation, the first depth △L of the first recess 105 may be half of the difference between the fourth width L4 and the third width L3, where △L = (L4-L3)/2.

In an exemplary implementation, the first depth △L of the first recess 105 may be from about 0.05µm to about 0.2µm.

In an exemplary implementation, a difference between the second width L2 and the fourth width L4 may be about 0.8µm such that an orthographic projection of the first recess 105 on the base substrate 10 does not overlap an orthographic projection of the pixel opening 35 on the base substrate 10.

In an exemplary implementation, the fourth width L4 may be smaller than the second width L2, and the third width L3 may be smaller than the fourth width L4, i.e., L3 < L4 < L2.

In an exemplary implementation, a surface of the second insulating layer 102 on a side away from the base substrate 10 is provided with a second recess 106 recessed in a direction toward the base substrate 10. An inner wall of the second recess 106 on a side close to the base substrate 10 is located between a surface of the first electrode 31 on a side away from the base substrate 10 and a surface of the first electrode 31 on a side close to the base substrate 10. The second recess 106 may be in the shape of a curved surface with curvature. The second recess 106 may have a second depth △D. The second depth △D may be a maximum distance between an inner wall of the second recess 106 on a side close to the base substrate 10 and a surface of the second insulating layer 102 on a side away from the base substrate 10. The second depth △D may be a dimension of the second recess in a direction perpendicular to the base substrate 10.

In an exemplary implementation, the second depth △D of the second recess 106 may be from about 0.01µm to 0.06µm. In a direction away from the base substrate 10, a cross-sectional dimension of the second recess 106 gradually increases.

In an exemplary implementation, the first depth △L of the first recess 105 is greater than the second depth △D of the second recess 106.

In an exemplary implementation, a first height △H of the first recess 105 is greater than the second depth △D of the second recess 106. The first height △H of the first recess 105 is a maximum distance between a surface of the first recess 105 on a side close to the base substrate 10 and a surface of the first recess 105 on a side away from the base substrate 10.

In an exemplary implementation, a surface of the fourth insulating layer 104 on a side away from the base substrate 10 is provided with a third recess 109 that is smoothly recessed in a direction toward the base substrate 10. The third recess 109 may be in the shape of a curved surface with curvature. The curvature of the third recess 109 is less than the curvature of the first recess 105 or the curvature of the second recess 106.

In an exemplary implementation, the display substrate further includes an organic light emitting layer 33 disposed on a side of the first electrode 31 and the pixel definition structure 32 away from the base substrate 10. The organic light emitting layer 33 includes a plurality of film layers. At least one of the film layers is broken at an edge of the fourth insulating layer 104. The film layer of the organic light emitting layer 33 is provided with a distortion region 107 at the broken position, as shown in a dashed box. In an exemplary implementation, the distortion region 107 may include at least one crack, and a segment difference is formed in the organic light emitting layers 33 on both sides of the crack due to the breakage.

In an exemplary implementation, an orthographic projection of the distortion region 107 on the base substrate 10 does not overlap an orthographic projection of the pixel opening 35 on the base substrate 10.

In an exemplary implementation, the display substrate further includes a second electrode 34 disposed on a side of the organic light emitting layer 33 away from the base substrate 10. The second electrode 34 is provided with a puncture tip 108 disposed in the crack in the distortion region 107. An orthogonal projection of the puncture tip 108 on the base substrate 10 does not overlap an orthogonal projection of the first electrode 31 on the base substrate 10.

An orthographic projection of an end point of the puncture tip 108 on the base substrate 10 is located within the range of an orthographic projection of the first insulating layer 101 on the base substrate 10. The end point of the puncture tip 108 is a boundary point closest to the base substrate 10 on the puncture tip 108.

In an exemplary embodiment, in the pixel definition structure 32, the first insulating layer 101 has a first thickness D1, the second insulating layer 102 has a second thickness D2, the third insulating layer 103 has a third thickness D3, and the fourth insulating layer 104 has a fourth thickness D4. The first thickness D1, the second thickness D2, the third thickness D3, and the fourth thickness D4 are dimensions in a direction perpendicular to the base substrate 10. The first thickness D1 may be from about 900 angstroms to about 1100 angstroms. For example, the first thickness D1 may be about 1000 angstroms. The second thickness D2 may be about 300 angstroms to 500 angstroms. For example, the second thickness D2 may be about 400 angstroms. The third thickness D3 may be about 500 angstroms to 700 angstroms. For example, the third thickness D3 may be about 600 angstroms. The fourth thickness D4 may be about 100 angstroms to 300 angstroms. For example, the fourth thickness D4 may be about 200 angstroms.

Exemplary description is made below through a preparation process of a display substrate. A "patterning process" mentioned in the present disclosure includes a treatment such as deposition of a film layer, photoresist coating on a film layer, mask exposure, development, etching, and photoresist stripping for a metal material, an inorganic material, or a transparent conductive material, and includes a treatment such as organic material coating, mask exposure, and development for an organic material. Deposition may be any one or more of sputtering, evaporation deposition, and chemical vapor deposition, coating may be any one or more of spray coating, spin coating, and inkjet printing, and etching may be any one or more of dry etching and wet etching. The present disclosure is not limited thereto. A "thin film" refers to a layer of thin film which is made of a material on a base substrate by using deposition, coating, or other processes. If the "thin film" does not need to be processed through a patterning process in the entire manufacturing process, the "thin film" may also be called a "layer". If the "thin film" needs to be processed through the patterning process in the entire manufacturing process, the "thin film" is called a "thin film" before the patterning process is performed and is called a "layer" after the patterning process is performed. At least one "pattern" is contained in the "layer" which has been processed through the patterning process. "A and B are arranged at the same layer" in the present disclosure means that A and B are formed simultaneously through the same patterning process. In the exemplary embodiment of the present disclosure, "an orthographic projection of B is located within the range of an orthographic projection of A" or "an orthographic projection of A includes an orthographic projection of B" means that the boundary of the orthographic projection of B falls within the boundary range of the orthographic projection of A, or the boundary of the orthographic projection of A coincides with the boundary of the orthographic projection of B.

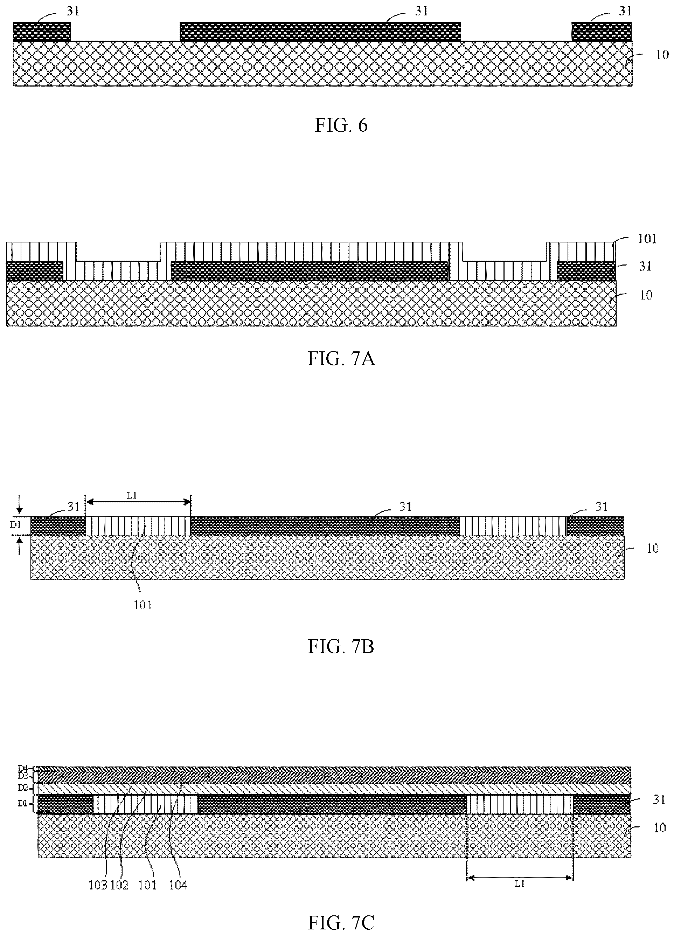

In an exemplary implementation, taking three sub-pixels of the display substrate as an example, a manufacturing process of the display substrate may include the following operations.
A. Forming a pattern of a first conductive layer. In an exemplary implementation, forming a pattern of a first conductive layer may include depositing a first conductive thin film on a base substrate 10, and patterning the first conductive thin film by a patterning process to form a pattern of a first conductive layer. The pattern of the first conductive layer includes at least a first electrode 31 located in each sub-pixel, as shown in FIG. 6.

In an exemplary implementation, the first electrode 31 may be made of a metal material or a transparent conductive material, and the metal material may include any one or more of silver (Ag), copper (Cu), aluminum (Al), titanium (TI), and molybdenum (Mo), or an alloy material of the above metals, and the transparent conductive material may include Indium Tin Oxide (ITO) or Indium Zinc Oxide (IZO). In an exemplary implementation, the first electrode 31 may be of a single-layered structure or a multi-layered composite structure. In an exemplary implementation, the multi-layered composite structure may include a Ti layer, an Al layer, a titanium nitride (TiN) layer, and an ITO layer sequentially disposed in a direction away from the base substrate 10, which may meet the conventional requirements of high reflectivity, low roughness, and work function matching of light emitting devices.

In an exemplary implementation, the first electrode 31 has a first electrode thickness, the first electrode thickness may be from about 900 angstroms to 1100 angstroms, and the first electrode thickness is a dimension in a direction perpendicular to the base substrate 10. For example, the first thickness D1 may be about 1000 angstroms.

B. Forming a pattern of a pixel definition structure. In an exemplary implementation, the pattern of the pixel definition structure includes at least a pixel definition structure 32 located in each sub-pixel. The pixel definition structure 32 is disposed between adjacent first electrodes 31 and forms a pixel opening that exposes a first electrode 31. Forming a pattern of a pixel definition structure may include:
B1. Forming a pattern of a first insulating layer. In an exemplary implementation, forming a pattern of a first insulating layer may include first depositing a first insulating thin film on a substrate on which the above pattern is formed, as shown in FIG. 7A. Subsequently, the first insulating thin film is etched by a full-face back-etching process to form the first insulating layer 101, as shown in FIG. 7B.

In an exemplary implementation, the first insulating layer 101 is provided between adjacent first electrodes 31. An orthographic projection of the first insulating layer 101 on the base substrate 10 does not overlap an orthographic projection of the first electrode 31 on the base substrate 10, and a side surface of the first insulating layer 101 can be bonded to a side surface of the first electrode 31.

In an exemplary implementation, by the full-face back-etching process, a surface of the first insulating layer 101 on a side away from the base substrate 10 is substantially flush with a surface of the first electrode 31 on a side away from the base substrate 10. A surface of the first insulating layer 101 on a side away from the base substrate 10 is lower than a surface of the first electrode 31 on a side away from the base substrate 10.

In an exemplary implementation, the first insulating layer 101 may be a planarization layer. A side surface of the first insulating layer 101 can be bonded to a side surface of the first electrode 31, so that a flat region of a predetermined width is formed at the point where the first insulating layer 101 comes into contact with the first electrode. The first insulating layer 101 has a first width L1, the first width L1 being a dimension in a direction parallel to the base substrate 10. In an exemplary implementation, the first width L1 may be about 1.0µm to 1.2µm. For example, the first width L1 may be about 1.1µm.

In an exemplary implementation, the first insulating layer 101 may have a first thickness D1. The first thickness D1 may be from about 900 angstroms to about 1100 angstroms. For example, the first thickness D1 may be about 1000 angstroms.

In an exemplary implementation, the material of the first insulating layer 101 is an inorganic material. For example, the material of the first insulating layer 101 is silicon oxide (SiOx).

B2. Forming a pattern of a second insulating thin film, a third insulating thin film, and a fourth insulating thin film. In an exemplary implementation, forming a pattern of a second insulating thin film, a third insulating thin film, and a fourth insulating thin film may include sequentially depositing a second insulating thin film, a third insulating thin film, and a fourth insulating thin film on a substrate forming the foregoing pattern, as shown in FIG. 7C.

In an exemplary implementation, the second insulating layer 102 in the pixel definition structure 32 has a second thickness D2, and the second thickness D2 is a dimension of the second insulating layer 102 in a direction perpendicular to the base substrate 10. The second thickness D2 may be about 300 angstroms to 500 angstroms. For example, the second thickness D2 may be about 400 angstroms. In an exemplary implementation, the third insulating layer 103 has a third thickness D3, and the third thickness D3 is a dimension of the third insulating layer 103 in a direction perpendicular to the base substrate 10. The third thickness D3 may be about 500 angstroms to 700 angstroms. For example, the third thickness D3 may be about 600 angstroms. In an exemplary implementation, the fourth insulating layer 104 has a fourth thickness D4, and the fourth thickness D4 is a dimension of the fourth insulating layer 104 in a direction perpendicular to the base substrate 10. The fourth thickness D4 may be about 100 angstroms to 300 angstroms. For example, the fourth thickness D4 may be about 200 angstroms.

In an exemplary implementation, the second insulating thin film, the third insulating thin film, and the fourth insulating thin film are all inorganic materials, the material of the third insulating thin film may be different from the material of the fourth insulating thin film, and the material of the second insulating thin film may be the same as the material of the fourth insulating thin film. For example, the material of the second insulating thin film and the fourth insulating thin film is silicon oxide (SiOx), and the material of the third insulating thin film is silicon nitride (SiNx)_{∘}

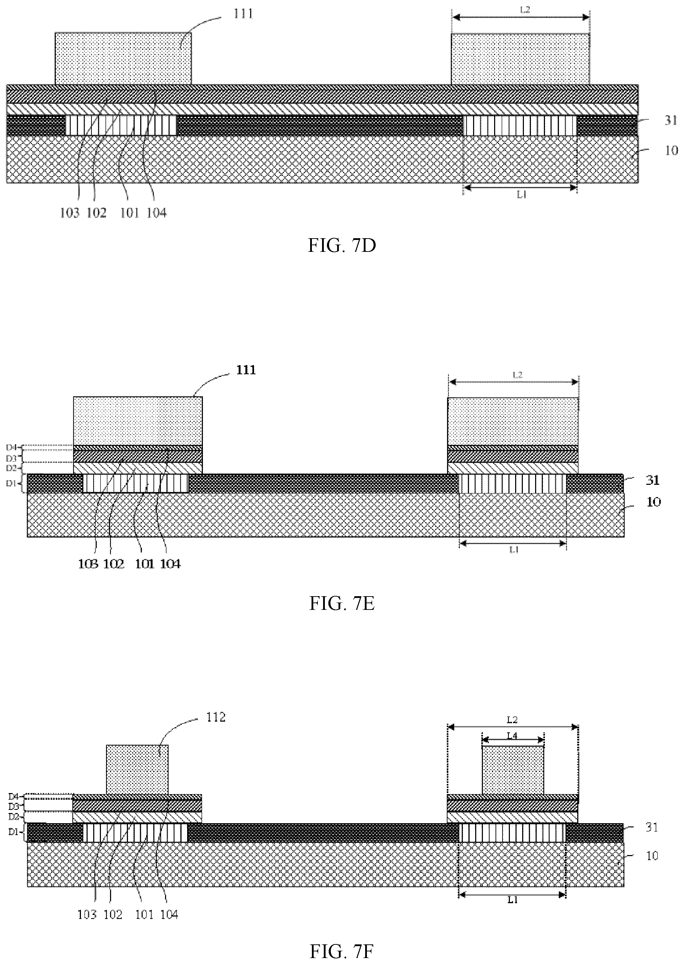

B3. First, coating a photoresist on the fourth insulating thin film, and forming a first photoresist pattern 111 by exposure and development, as shown in FIG. 7D.

In an exemplary implementation, the first photoresist pattern 111 has a second width L2, and the second width L2 is a dimension of the second photoresist pattern 112 in a direction parallel to the base substrate 10. The second width L2 may be larger than the first width L1. In an exemplary implementation, the second width L2 may be about 1.2µm to 1.6µm. For example, the second width L2 may be about 1.4µm.

Subsequently, the second insulating thin film, the third insulating thin film, and the fourth insulating thin film not coated with photoresist are etched to form a first transition pattern, as shown in FIG. 7E.

In an exemplary implementation, the first transition pattern may include a second insulating layer 102, a third insulating layer 103, and a fourth insulating layer 104 which are stacked. The second insulating layer 102, the third insulating layer 103, and the fourth insulating layer 104 has substantially the same second width L2.

In an exemplary implementation, an orthographic projection of the second insulating layer 102 on the base substrate 10 includes an orthographic projection of the first insulating layer 101 on the base substrate 10. The orthographic projection of the second insulating layer 102 on the base substrate 10 at least partially overlaps the orthographic projection of the first electrode 31 on the base substrate 10.

In an exemplary implementation, an orthographic projection of the second insulating layer 102 on the base substrate 10 at least partially overlaps an orthographic projection of the first electrode 31 on the base substrate 10, and at least partially exposes the first electrode 31.

In an exemplary implementation, the difference between the second width L2 of the second insulating layer 102 and the first width L1 of the first insulating layer 101 is greater than or equal to 0.1µm. A width of a region where the second insulating layer 102 overlaps the first electrode 31 may be greater than 0.1µm, so that the second insulating layer 102 can effectively cover the edges of the first electrode 31. That is to say, the pixel definition structure 32 does not expose an edge of the first electrode 31 and is provided by forming a second insulating layer 102 which is wider than the first insulating layer 101.

In an exemplary implementation, the difference between the second width L2 and the first width L1 may be about 0.3µm, such that the second insulating layer 102 effectively covers one side of the first electrode 31 by about 0.15µm.

B4. First, reducing the width of the photoresist pattern by using a photoresist indentation method to form a second photoresist pattern 112, as shown in FIG. 7F.

In an exemplary implementation, the second photoresist pattern 113 has a fourth width L4, and the fourth width L4 is a dimension of the third photoresist pattern 113 in a direction parallel to the base substrate 10. The fourth width L4 may be about 0.5µm to 0.7µm. For example, the fourth width L4 may be about 0.6µm.

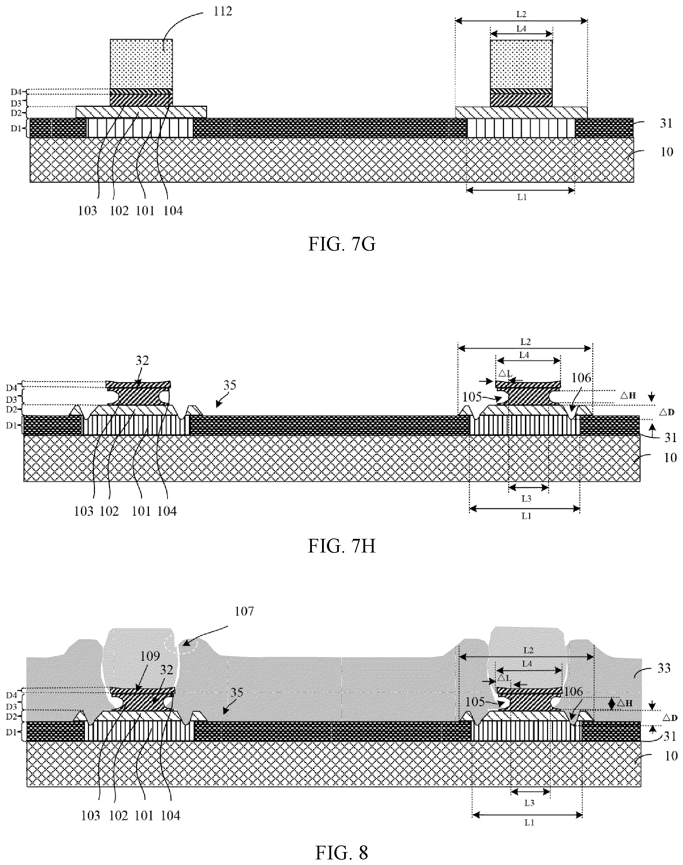

Subsequently, the exposed third insulating layer 103 and the exposed fourth insulating layer 104 are etched to form a pattern of a second transition pattern, as shown in FIG. 7G.

In an exemplary implementation, the second transition pattern may include a third insulating layer 103 and a fourth insulating layer 104 which are stacked. The third insulating layer 103 and the fourth insulating layer 104 have substantially the same fourth width L4.

In an exemplary implementation, an orthographic projection of the third insulating layer 103 on the base substrate 10 does not overlap an orthographic projection of the first electrode 31 on the base substrate 10, and an orthographic projection of the fourth insulating layer 104 on the base substrate 10 does not overlap an orthographic projection of the first electrode 31 on the base substrate 10.

In an exemplary implementation, the fourth width L4 may be smaller than the first width L1, i.e., L4 < L1.

In an exemplary implementation, in an exemplary implementation, the fourth width L4 may be smaller than the second width L2, i.e., L4 < L2. The difference between the fourth width L4 and the second width L2 may be greater than or equal to 0.3µm.

Subsequently, a side surface of the third insulating layer 103 is etched by changing the proportion of the etching gas, so that the fourth insulating layer 104 has a protrusion relative to a side wall of the third insulating layer 103, and the protrusion and the side wall of the third insulating layer 103 form a first recess 105. In this etching process, the etching gas etches a surface of the second insulating layer 102 on a side away from the base substrate 10 to form a second recess 106 on the surface of the second insulating layer 102. In this etching process, the etching gas etches a surface of the fourth insulating layer 104 on a side away from the base substrate 10 to form a third recess 109. After removing the remaining photoresist, a pattern of a pixel definition structure is formed, as shown in FIG. 7H.

In an exemplary implementation, the pixel definition structure 32 may include a second insulating layer 102, a third insulating layer 103, and a fourth insulating layer 104 sequentially disposed on the first insulating layer 101. An orthographic projection of the first insulating layer 101 on the base substrate is located within the range of an orthographic projection of the second insulating layer 102 on the base substrate. An orthographic projection of the fourth insulating layer 1044 on the base substrate is located within a range of an orthographic projection of the first insulating layer 101 on the base substrate. An orthographic projection of the third insulating layer 103 on the base substrate is located within a range of an orthographic projection of the fourth insulating layer 104 on the base substrate.

In an exemplary implementation, the first insulating layer 101 has a first width L1, the second insulating layer 102 has a second width L2, the third insulating layer 103 has a third width L3, and the fourth insulating layer 104 has a fourth width L4. In an exemplary implementation, the first width L1 may be smaller than the second width L2, the fourth width L4 may be smaller than the first width L1, and the third width L3 may be smaller than the fourth width L4, that is, L3 < L4 < L1 < L2. The first width L1, the second width L2, the third width L3, and the fourth width L4 are dimensions in a direction parallel to the base substrate 10.

In an exemplary implementation, the third width L3 may be a minimum width of the third insulating layer 103, and the fourth width L4 may be a maximum width of the fourth insulating layer 104. Alternatively, the third width L3 may be an average width of the third insulating layer 103, and the fourth width L4 may be an average width of the fourth insulating layer 104.

In an exemplary implementation, the difference between the fourth width L4 and the third width L3 may be about 0.1µm to 0.4µm.

In an exemplary implementation, the third width L3 may be about 0.3µm to 0.5µm. In an exemplary implementation, the third width L3 may be about 0.4µm.

In an exemplary implementation, the fourth insulating layer 104 has a protrusion relative to a side wall of the third insulating layer 103, and the protrusion and the side wall of the third insulating layer 103 form a first recess 105 recessed in a direction away from the pixel opening 35. The first recess 105 may be in the shape of a curved surface with curvature.

In an exemplary implementation, the first recess 105 may have a first depth △L, which may be a maximum distance between a side wall of the fourth insulating layer 104 on a side close to the pixel opening 35 and a side wall of the third insulating layer 103 on a side close to the pixel opening 35.

In an exemplary implementation, the first depth △L of the first recess 105 may be half of the difference between the fourth width L4 and the third width L3, where △L = (L4-L3)/2.

In an exemplary implementation, the first depth △L of the first recess 105 may be from about 0.05µm to about 0.2µm.

In an exemplary implementation, the difference between the second width L2 and the fourth width L4 may be about 0.8µm such that an orthographic projection of the first recess 105 on the base substrate 10 does not overlap an orthographic projection of the pixel opening 35 on the base substrate 10.

In an exemplary implementation, a surface of the second insulating layer 102 on a side away from the base substrate 10 is provided with a second recess 106 recessed in a direction toward the base substrate 10. An inner wall of the second recess 106 on a side close to the base substrate 10 is located between a surface of the first electrode 31 on a side away from the base substrate 10 and a surface of the first electrode 31 on a side close to the base substrate 10. The second recess 106 may be in the shape of a curved surface with curvature. The second recess 106 may be in the shape of a curved surface with curvature. The second recess 106 may have a second depth △D. The second depth △D may be a maximum distance between an inner wall of the second recess 106 on a side close to the base substrate 10 and a surface of the second insulating layer 102 on a side away from the base substrate 10. The second depth △D may be a dimension of the second recess in a direction perpendicular to the base substrate 10.

In an exemplary implementation, the second depth △D of the second recess 106 may be from about 0.01µm to 0.06µm. In a direction away from the base substrate 10, a cross-sectional dimension of the second recess 106 gradually increases.

In an exemplary implementation, the first depth △L of the first recess 105 is greater than the second depth △D of the second recess 106.

In an exemplary implementation, the first height △H of the first recess 105 is greater than the second depth △D of the second recess 106. The first height △H of the first recess 105 is a maximum distance between a surface of the first recess 105 on a side close to the base substrate 10 and a surface of the first recess 105 on a side away from the base substrate 10.

In an exemplary implementation, a surface of the fourth insulating layer 104 on a side away from the base substrate 10 is provided with a third recess 109 that is smoothly recessed in a direction toward the base substrate 10. The third recess 109 may be in the shape of a curved surface with curvature. The curvature of the third recess 109 is less than the curvature of the first recess 105 or the curvature of the second recess 106.

C. Forming a pattern of an organic light emitting layer. In an exemplary implementation, forming a pattern of an organic light emitting layer may include forming a pattern of an organic light emitting layer by evaporation deposition or the like, and the organic light emitting layer 33 of each sub-pixel is connected to the first electrode 31 of the sub-pixel through the pixel opening 35, as shown in FIG. 8.

In an exemplary implementation, the organic light emitting layer 33 may include a plurality of film layers. At least one of the film layers is broken at an edge of the fourth insulating layer 104. In an exemplary implementation, a film layer of the organic light emitting layer 33 is provided with a distortion region 107 at the broken position. Breakage of a film layer of the organic light emitting layer 33 occurs in the distortion region 107 as shown by the dashed line box. In an exemplary implementation, the distortion region 107 may include at least one crack, and a segment difference is formed in the organic light emitting layers 33 on both sides of the crack due to the breakage.

In an exemplary implementation, an orthographic projection of the distortion region 107 on the base substrate 10 does not overlap an orthographic projection of the pixel opening 35 on the base substrate 10.

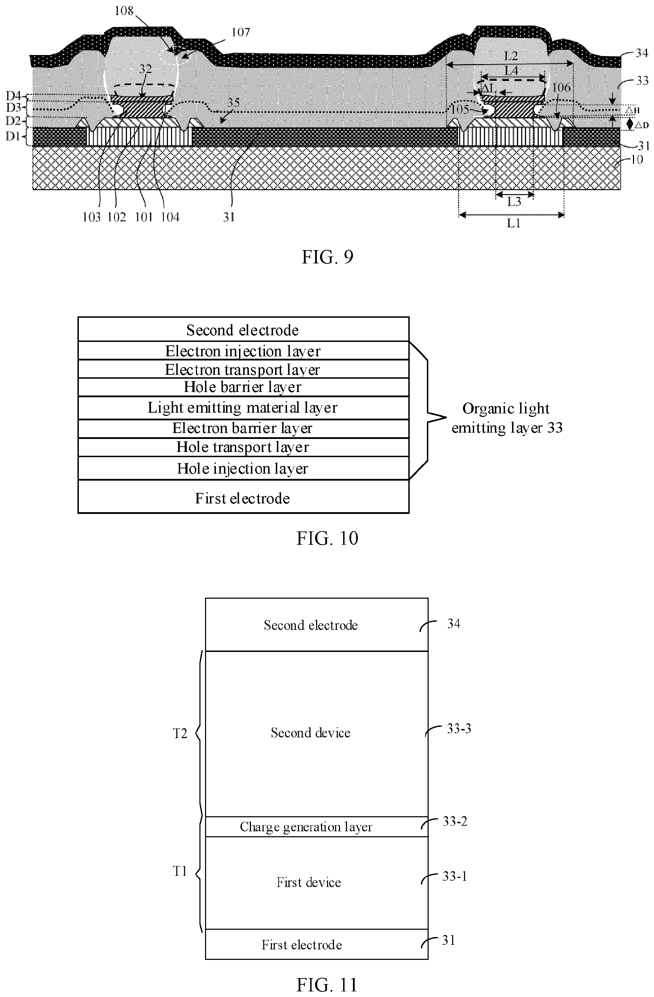

D. Forming a pattern of a second conductive layer. In an exemplary implementation, forming a pattern of a second conductive layer may include forming a second electrode 34 by evaporation deposition or other deposition. The second electrode 34 is provided on a side of the organic light emitting layer 33 away from the base substrate 10, and has a full-face structure, as shown in FIG. 9.

In an exemplary implementation, the distortion region 107 is formed in the organic light emitting layer 33, such that the second electrode 34 is provided with a puncture tip 108, and the puncture tip 108 is provided in a crack in the distortion region 107.

An orthographic projection of an end point of the puncture tip 108 on the base substrate 10 is located within the range of an orthographic projection of the first insulating layer 101 on the base substrate 10. The end point of the puncture tip 108 is a boundary point closest to the base substrate 10 on the puncture tip 108.

In an exemplary implementation, an orthographic projection of the puncture tip 108 on the base substrate 10 does not overlap an orthographic projection of the first electrode 31 on the base substrate 10.

In an exemplary implementation, the second electrode 34 may be made of a metal material or a transparent conductive material. The metal material may include any one or more of magnesium (Mg), silver (Ag), aluminum (Al), copper (Cu), and lithium (Li), or an alloy material of the aforementioned metals, and the transparent conductive material may include indium zinc oxide (IZO). In an exemplary implementation, the second electrode 34 may be of a single-layered structure or a multi-layered composite structure, such as Mg/Ag.

In an exemplary implementation, a pattern of an optical coupling layer may be formed after a pattern of a second conductive layer is formed. The optical coupling layer is provided on the second electrode 34. A refractive index of the optical coupling layer may be greater than a refractive index of the second electrode 34, which facilitates light extraction and increases light emitting efficiency. The optical coupling layer may be made of an organic material, or an inorganic material, or both, and may be a single layer, a multi-layer, or a composite layer, which is not limited here in the present disclosure.

So far, the preparation of a display substrate is completed. The display substrate may include a base substrate 10, a first electrode 31, a pixel definition structure 32, an organic light emitting layer 33, and a second electrode 34. The organic light emitting layer 33 emits light under the drive of the first electrode 31 and the second electrode 34.

Subsequent preparation may include processes such as forming a first encapsulation layer 40, a color film structure layer 50, a second encapsulation layer 60, and a cover plate layer 70, which will not be described here.

In a display substrate provided by the present disclosure, a pixel definition structure including a plurality of insulating layers is provided, and a second recess is formed on the second insulating layer in the pixel definition structure, and an inner wall of the second recess on a side close to the base substrate is located between an upper surface and a lower surface of the first electrode. In this way, it can be ensured that the second electrode will not be broken while the pixel definition structure partitions the organic light emitting layer, and the continuity of the second electrode can be ensured. By forming a first recess on the side wall of the pixel definition structure so that the organic light emitting layer is broken at an edge of the pixel definition structure, the pixel definition structure proposed in the present disclosure can effectively block the lateral current in the organic light emitting layer. The pixel definition structure proposed in the present disclosure makes the organic light emitting layer form a distortion region, and an orthographic projection of the distortion region on the base substrate does not overlap an orthographic projection of the pixel opening on the base substrate, that is, the distortion region is located outside the pixel opening and away from the effective light emitting region, thereby improving the light emitting efficiency and reducing the brightness loss. The pixel definition structure proposed in the present disclosure ensures that an orthogonal projection of the puncture tip of the second electrode on the base substrate does not overlap an orthogonal projection of the first electrode on the base substrate, that is, the puncture tip is located outside the area where the first electrode is located, which can effectively avoid the short circuit between the second electrode and the first electrode. By providing the puncture tip in the area where the flat first insulating layer is located, the continuity of the second electrode can be further guaranteed, and virtual connection or disconnection will not occur.

The organic light emitting layer is broken at the edge of the pixel definition structure, which can effectively avoid crosstalk caused by the charge generation layer transferring carriers, greatly reduce the risk of longitudinal leakage of the organic light emitting device, improve the luminous efficiency, and improve the display effect.

FIG. 10 is a schematic diagram of a structure of an organic light emitting layer in an exemplary embodiment of the present disclosure. As shown in FIG. 10, the organic light emitting layer 33 may include a hole injection layer, a hole transport layer, an electron barrier layer, a light emitting material layer, a hole barrier layer, an electron transport layer, and an electron injection layer disposed between the first electrode and the second electrode.

FIG. 11 is a schematic diagram of a structure of another organic light emitting layer in an exemplary embodiment of the present disclosure. As shown in FIG. 11, the organic light emitting layer 33 may include a first device 33-1, a charge generation layer 33-2, and a second device 33-3 disposed between the first electrode and the second electrode. The first device 33-1 and the second device 33-3 each include a hole injection layer, a hole transport layer, an electron barrier layer, a light emitting material layer, a hole barrier layer, an electron transport layer, and an electron injection layer which are stacked.

In an exemplary implementation, in a direction perpendicular to the base substrate 10, the first device 33-1 and the charge generation layer 33-2 have a first device thickness T1, and the second stacked device 33-3 has a second thickness T2. The first device thickness T1 may be smaller than the second device thickness T2, that is, T1 < T2.

In an exemplary implementation, the first device thickness T1 may be less than half of the second device thickness T2, that is, T1 < 1/2*T2, to ensure that the in-cut structure effectively partitions the organic light emitting layer 33 without causing virtual connection or breaking of the second electrode 34.

In an exemplary implementation, the third thickness D3 may be less than the first device thickness T1, and the third thickness D3 may be greater than half of the first device thickness T1, i.e., 1/2*T1 < D3 < T1, ensuring that at least one film layer in the organic light emitting layer 33 is broken at a position corresponding to the pixel definition structure 32, and in particular partitioning the charge generation layer 33-2 in the organic light emitting layer 33.

In an exemplary implementation, the total thickness of the organic light emitting layer 33 may be from about 2900 angstroms to about 3100 angstroms. The first device thickness T1 may be about 900 angstroms and the second device thickness T2 may be about 2100 angstroms.

Through research, it is found that not only the width of the inorganic layer in the pixel definition structure affects the efficiency and lifetime of the light emitting device, but also the thickness of the organic light emitting layer is a factor affecting the quality of the light emitting device. By setting the thickness relationship between the third insulating layer and the organic light emitting layer, the present disclosure not only further effectively blocks the lateral leakage between pixels, but also reduces the longitudinal leakage caused by the distortion of the organic light emitting layer.

An exemplary embodiment of the present disclosure further provides a manufacturing method for a display substrate. In an exemplary implementation, the manufacturing method includes: forming a plurality of first electrodes and a plurality of pixel definition structures on a base substrate. The pixel definition structures are disposed between adjacent first electrodes and form pixel openings exposing the first electrodes. In a direction perpendicular to the base substrate, the pixel definition structure at least includes a first insulating layer disposed on the base substrate, a second insulating layer disposed on a side of the first insulating layer away from the base substrate, a third insulating layer disposed on a side of the second insulating layer away from the base substrate, and a fourth insulating layer disposed on a side of the third insulating layer away from the base substrate. Orthographic projections of the first insulating layer, the third insulating layer and the fourth insulating layer on the base substrate do not overlap an orthographic projection of a first electrode on the base substrate, and an orthographic projection of the second insulating layer on the base substrate at least partially overlaps the orthographic projection of the first electrode on the base substrate. A surface of the second insulating layer away from the base substrate is provided with a second recess recessed in a direction toward the base substrate, and an inner wall of the second recess on a side close to the base substrate is located between a surface of the first electrode on a side away from the base substrate and a surface of the first electrode on a side close to the base substrate.

The present disclosure also provides a display apparatus which includes the display substrate according to the aforementioned embodiments. The display apparatus may be any product or component with a display function, such as a mobile phone, a tablet computer, a television, a display, a laptop computer, a digital photo frame, or a navigator.

Although the implementations of the present disclosure are disclosed above, the contents are only implementations used for ease of understanding of the present disclosure, but not intended to limit the present disclosure. Any skilled person in the art to which the present disclosure pertains may make any modification and alteration in forms and details of implementation without departing from the spirit and scope of the present disclosure. However, the scope of patent protection of the present disclosure should be subject to the scope defined by the appended claims.

## Claims

1. A display substrate comprising a base substrate, and a plurality of first electrodes and a plurality of pixel definition structures disposed on the base substrate, the pixel definition structures being disposed between adjacent first electrodes and forming pixel openings exposing the first electrodes; wherein in a direction perpendicular to the base substrate, a pixel definition structure at least comprises a first insulating layer disposed on the base substrate, a second insulating layer disposed on a side of the first insulating layer away from the base substrate, a third insulating layer disposed on a side of the second insulating layer away from the base substrate, and a fourth insulating layer disposed on a side of the third insulating layer away from the base substrate, orthographic projections of the first insulating layer, the third insulating layer and the fourth insulating layer on the base substrate do not overlap an orthographic projection of a first electrode on the base substrate, and an orthographic projection of the second insulating layer on the base substrate at least partially overlaps the orthographic projection of the first electrode on the base substrate; and wherein a surface of the second insulating layer away from the base substrate is provided with a second recess recessed in a direction toward the base substrate, and an inner wall of the second recess on a side close to the base substrate is located between a surface of the first electrode on a side away from the base substrate and a surface of the first electrode on a side close to the base substrate.

2. The display substrate according to claim 1, wherein a second depth of the second recess is 0.01µm to 0.06µm, and the second depth is a maximum distance between the inner wall of the second recess on a side close to the base substrate and a surface of the second insulating layer on a side away from the base substrate.

3. The display substrate according to claim 1, wherein a surface of the first insulating layer on a side away from the base substrate is flush with a surface of the first electrode on a side away from the base substrate, or a surface of the first insulating layer on a side away from the base substrate is lower than a surface of the first electrode on a side away from the base substrate.

4. The display substrate according to claim 1, wherein the first insulating layer has a first width, the second insulating layer has a second width, the second width is greater than the first width, and the first width and the second width are dimensions in a direction parallel to the base substrate.

5. The display substrate according to claim 4, wherein a difference between the second width and the first width is greater than or equal to 0.1µm.

6. The display substrate according to claim 1, wherein a material of the third insulating layer is different from a material of the fourth insulating layer, and a material of the second insulating layer is the same as the material of the fourth insulating layer.

7. The display substrate according to claim 4, wherein the third insulating layer has a third width, the fourth insulating layer has a fourth width, the fourth width is less than the second width, the fourth width is less than the first width, the third width is less than the fourth width, and the third width and the fourth width are dimensions in a direction parallel to the base substrate.

8. The display substrate according to claim 7, wherein a difference between the fourth width and the second width is greater than or equal to 0.3µm, and a difference between the fourth width and the third width is 0.1µm to 0.4µm.

9. The display substrate according to claim 2, wherein the fourth insulating layer has a protrusion relative to a side wall of the third insulating layer, and the protrusion and the side wall of the third insulating layer form a first recess recessed in a direction away from a pixel opening, a first depth of the first recess being greater than the second depth of the second recess, the first depth being a maximum distance between a side wall of the fourth insulating layer on a side close to the pixel opening and a side wall of the third insulating layer on a side close to the pixel opening.

10. The display substrate according to claim 9, wherein the first depth of the first recess is 0.05µm to 0.2µm .

11. The display substrate according to claim 9, wherein a first height of the first recess is greater than the second depth of the second recess, and the first height of the first recess is a maximum distance between a surface of the first recess on a side close to the base substrate and a surface of the first recess on a side away from the base substrate.

12. The display substrate according to claim 11, wherein a surface of the fourth insulating layer on a side away from the base substrate is provided with a third recess that is smoothly recessed in a direction toward the base substrate.

13. The display substrate according to claim 12, wherein a curvature of the third recess is less than a curvature of the first recess or a curvature of the second recess.

14. The display substrate according to any one of claims 1 to 13, wherein the display substrate further comprises an organic light emitting layer disposed on a side of the first electrodes and the pixel definition structures away from the base substrate, the organic light emitting layer comprises a plurality of film layers, at least one film layer is broken at an edge of the fourth insulating layer, and a film layer of the organic light emitting layer is provided with a distortion region at a broken position.

15. The display substrate according to claim 14, wherein the distortion region comprises at least one crack, and an orthographic projection of the distortion region on the base substrate does not overlap an orthographic projection of the pixel openings on the base substrate.

16. The display substrate according to claim 15, wherein the display substrate further comprises a second electrode disposed on a side of the organic light emitting layer away from the base substrate, the second electrode is provided with a puncture tip disposed in the crack in the distortion region, and an orthographic projection of the puncture tip on the base substrate does not overlap an orthographic projection of the first electrode on the base substrate; and
wherein an orthographic projection of an end point of the puncture tip on the base substrate is located within a range of an orthographic projection of the first insulating layer on the base substrate, and the end point of the puncture tip is a boundary point closest to the base substrate on the puncture tip.

17. The display substrate according to claim 14, wherein the organic light emitting layer comprises a first device, a charge generation layer and a second device which are stacked, the first device and the charge generation layer having a first device thickness, the second device having a second device thickness, the first device thickness being smaller than the second device thickness, the first device thickness and the second device thickness being dimensions in a direction perpendicular to the base substrate.

18. The display substrate according to claim 17, wherein the first device thickness is less than 1/2 * the second device thickness.

19. The display substrate according to claim 17, wherein the third insulating layer has a third thickness D3, the third thickness D3 is a dimension in a direction perpendicular to the base substrate, the third thickness is less than the first device thickness, and the third thickness is greater than 1/2 * the first device thickness.

20. A display apparatus, comprising the display substrate according to any one of claims 1 to 19.

21. A manufacturing method for a display substrate, comprising:
forming a plurality of first electrodes and a plurality of pixel definition structures on a base substrate, wherein the pixel definition structures are disposed between adjacent first electrodes and form pixel openings exposing the first electrodes; and wherein in a direction perpendicular to the base substrate, a pixel definition structure at least comprises a first insulating layer disposed on the base substrate, a second insulating layer disposed on a side of the first insulating layer away from the base substrate, a third insulating layer disposed on a side of the second insulating layer away from the base substrate, and a fourth insulating layer disposed on a side of the third insulating layer away from the base substrate, orthographic projections of the first insulating layer, the third insulating layer and the fourth insulating layer on the base substrate do not overlap an orthographic projection of a first electrode on the base substrate, and an orthographic projection of the second insulating layer on the base substrate at least partially overlaps the orthographic projection of the first electrode on the base substrate; and wherein a surface of the second insulating layer away from the base substrate is provided with a second recess recessed in a direction toward the base substrate, and an inner wall of the second recess on a side close to the base substrate is located between a surface of the first electrode on a side away from the base substrate and a surface of the first electrode on a side close to the base substrate.
